# EUROPÄISCHE PATENTSCHRIFT

(11) **EP 2 797 398 B1**
(45) Veröffentlichungstag und Bekanntmachung des Hinweises auf die Patenterteilung: **20.06.2018**
(21) Anmeldenummer: 14000374.0
(22) Anmeldetag: 31.01.2014
(51) Int. Cl.: H05K 13/04, B65G 47/91, H01L 21/683, B25J 15/06

(54) **Bestückkopf zum Bestücken von Substraten mit elektrischen Bauelementen mittels einer pneumatischen Einrichtung**
Loading head for populating substrates with electrical components by means of a pneumatic device
Tête d'implantation destinée à l'implantation de substrats avec des composants électriques au moyen d'un dispositif pneumatique

(30) Priorität: 23.04.2013 DE 102013007068
(43) Veröffentlichungstag der Anmeldung: 29.10.2014
(73) Patentinhaber: MIMOT GmbH, 79539 Lörrach (DE)
(72) Erfinder: Mehdianpour, Mohammad, 81829 München (DE); Steiger, Daniel, 79400 Kandern-Tannenkirch (DE)
(74) Vertreter: Müller Hoffmann & Partner

(56) Entgegenhaltungen:
- EP-A2- 0 315 161
- DE-A1- 10 341 046
- JP-A- H07 297 594
- JP-A- 2012 080 064

## Beschreibung

Die Erfindung bezieht sich auf einen Bestückkopf zum Bestücken von Substraten mit elektrischen Bauelementen mit einem Gehäuse, an dem mehrere Halter für die Bauelemente in einer zum Substrat senkrechten Hubrichtung verschiebbar gelagert sind, wobei die Halter an ihrem dem Substrat zugewandten unteren Ende Saugöffnungen zum Ansaugen der Bauelemente aufweisen, wobei die Saugöffnungen schaltbar an eine Vakuumquelle und eine Druckluftquelle anschließbar sind, wobei jedem der Halter ein erstes und ein zweites Schaltventil zugeordnet ist, deren Ausgänge mit der zugeordneten Saugöffnung verbunden sind und wobei ein Eingang des ersten Schaltventils mit der Vakuumquelle und ein Eingang des zweiten Schaltventils mit der Druckluftquelle verbunden ist.
Ein derartiger Bestückkopf ist z.B. durch die WO2012014467 A bekannt geworden. In den Figuren 6 und 7 ist eine pneumatische Schaltung dargestellt, nach der eine Saugöffnung jeweils eines der Halter für die Bauelemente an die Ausgänge zweier elektromagnetisch betätigter Schaltventile angeschlossen ist, von denen ein erstes an die Vakuumquelle und ein zweites an die Druckluftquelle angeschlossen ist. Beim Abholen eines Bauelementes wird das erste Schaltventil geöffnet und damit die Saugöffnung mit der Vakuumquelle verbunden, wobei das zweite Schaltventil geschlossen ist. Das erste Schaltventil wird beim Aufsetzen des angesaugten Bauelements auf das Substrat geschlossen. Das zweite Schaltventil wird unmittelbar nach dem Aufsetzen des Bauelements geöffnet, so dass das Bauelement beim Abheben des Halters durch einen kurzen Druckluftimpuls sicher von der Saugöffnung abgelöst wird, worauf das zweite Schaltventil wieder geschlossen wird.

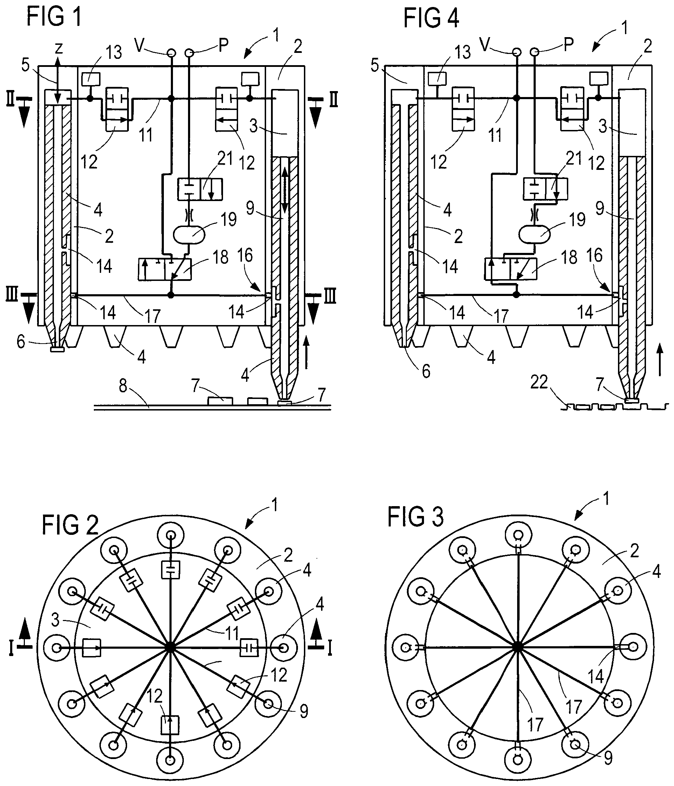

Das Dokument JP2012-80064 offenbart einen Bestückkopf gemäß dem Oberbegriff des Anspruchs 1. Der Erfindung liegt die Aufgabe zugrunde, den pneumatischen Vorrichtungs- und Steuerungsaufwand zu verringern.
Diese Aufgabe wird erfindungsgemäß durch einen Bestückkopf mit den Merkmalen von Anspruch 1 gelöst. Vorteilhafte Ausgestaltungen sind in den abhängigen Ansprüchen angegeben.
Ein Bestückkopf zum Bestücken von Substraten mit elektrischen Bauelementen weist ein Gehäuse auf, an dem mehrere Halter für die Bauelemente in einer zu dem Substrat senkrechten Richtung verschiebbar gelagert sind. Dabei weisen die Halter an ihrem dem Substrat zugewandten unteren Ende Saugöffnungen zum Ansaugen der Bauelemente auf. Die Saugöffnungen können schaltbar an eine Vakuumquelle und eine Druckluftquelle anschließbar sein, wobei jedem der Halter ein erstes und ein zweites Schaltventil zugeordnet ist, deren Ausgänge mit der zugeordneten Saugöffnung verbunden sind und wobei ein Eingang des ersten Schaltventils mit der Vakuumquelle und ein Eingang des zweiten Schaltventils mit der Druckluftquelle verbunden ist. Der Bestückkopf ist dadurch gekennzeichnet, dass die Eingänge der zweiten Schaltventile mit einem gemeinsame dritten Schaltventil verbunden sind, das mit der Druckluftquelle verbunden ist.
Die Betätigung der zweiten Schaltventile unmittelbar durch die Halterbewegung erübrigt die entsprechende elektrische Betätigung, wodurch sich der elektrische Steuerungs- und Verdrahtungsaufwand verringert. Durch den Wegfall der Elektromagnete verringern sich außerdem die thermische Belastung, der Raumbedarf und das Gewicht des Bestückkopfes. Das gemeinsame elektromagnetisch betätigbare dritte Schaltventil kompensiert die zeitliche Differenz zwischen Hubbewegung des Halters und dem Zeitraum des Druckimpulses. Durch die kinematische Kopplung des Halters mit dem zweiten Schaltventils muss sich dieses bereits vor dem Erreichen der unteren Aufsetzstellung öffnen. Unterschiedlich hohe Bauelemente bedingen einen relativ großen Hubbereich, in dem das zweite Schaltventil geöffnet bleiben muss. Dieser Hubbereich ist aber so begrenzt, dass alle anderen zweiten Schaltventile der nicht abgesenkten Halter sicher geschlossen bleiben. Dadurch wirkt das dritte Schaltventil nur auf den abgesenkten Halter. Der Druckluftimpuls lässt sich somit durch das dritte Schaltventil unabhängig von der Hubstellung des Halters genau auf das gewünschte Zeitfenster einstellen.
Bei einer Weiterbildung ist das zweite Schaltventil als mit dem Halter in der Hubrichtung fest gekoppeltes Schieberventil ausgebildet. Dabei können der Halter und das Gehäuse wechselseitige Gleitflächen aufweisen, die eine lineare Gleitführung für die Halter bilden und an denen das Schieberventil ausgebildet ist. Durch diese Weiterbildungen wird der Bau- und Raumaufwand für die zweiten Schaltventile weiter verringert.
Eine weitere Ausführungsform ist dadurch gekennzeichnet, dass die Gleitflächen mit wechselseitigen Öffnungen versehen sind, die einer oberen Hubstellung zueinander versetzt sind und die sich in einer abgesenkten unteren Hubstellung einander überdecken und dass die Öffnung im Träger bzw. Gehäuse mit dem dritten Schaltventil und die Öffnung im Halter mit der Saugöffnung verbunden ist. Dadurch kann hinsichtlich der Druckluftzuführung eine sichere funktionale Trennung zwischen den in einer oberen Wartestellung und den in der abgesenkten Hubstellung befindlichen Haltern erreicht werden. Eine hinreichende Längserstreckung der Öffnung ergibt eine Überschneidung der Öffnungen über einen Hubbereich des Halters für unterschiedliche Aufsetzhöhen.
Bei einer Weiterentwicklung sind die Öffnungen im Halter in der Nähe der Saugöffnungen angeordnet. Durch diese Anordnung wird der Druckluftimpuls in der Nähe der Saugöffnung auf kurzem Wege zugeführt.
Bei einer weiteren Ausführungsform kann ein erster Eingang des dritten Schaltventils über ein Volumen und ein Sperrventil mit der Druckluftquelle verbunden sein. Das Volumen kann ein Druckspeicher sein, der ohne hohen Steuerungsaufwand die für das Abblasen des Bauelements erforderliche Luftmenge bereitstellt. Es ist allerdings auch möglich, für das dritte Schaltventil ein genau regelbares Zeitsteuerventil zu verwenden, mit dem die erforderliche Luftmenge unmittelbar aus der Druckluftquelle entnommen werden kann. Ein zweiter Eingang des dritten Schaltventils ist mit der Vakuumquelle verbunden. Dabei kann das dritte Schaltventil als 3/2-Wege Umschaltventil ausgebildet sein. Dadurch ist es beim Abholen eines Bauelements aus einer Zuführeinrichtung möglich, die Schieberöffnungen an Vakuum anzuschließen, um das bereits über die ersten Schaltventile zugeführte Vakuum zu verstärken.
Im Folgenden wird die Erfindung anhand eines in der Zeichnung dargestellten Ausführungsbeispieles näher erläutert. Es zeigen:
**Figur 1** schematisiert einen Schnitt durch einen Bestückkopf entlang der Linie I - I in Figur 2,
**Figur 2** einen Schnitt durch den Bestückkopf entlang der Linie II - II in Figur 1,
**Figur 3** einen Schnitt durch den Bestückkopf entlang der Linie III - III in Figur 1,
**Figur 4** den Bestückkopf nach Figur 1 in einem anderen Betriebszustand,
**Figur 5** einen Funktionsablauf des Bestückkopfes in einer Abholphase, und
**Figur 6** den Funktionsablauf des Bestückkopfes in einer Bestückphase.
Nach den Figuren 1, 2 und 3 weist ein in einer waagerechten Ebene verfahrbarer Bestückkopf 1 ein Gehäuse 2 mit zueinander parallelen kreisförmig verteilten Bohrungen 3 auf, in denen im wesentlichen zylindrische Halter 4 in einer senkrechten Richtung z verschiebbar gleitgelagert sind. Die Halter 4 sind in nicht näher dargestellte Weise mit einem gemeinsamen Hubantrieb 5 einzeln koppelbar und höhenverstellbar. Sie weisen an ihrer unteren Stirnseite jeweils eine Saugöffnung 6 auf, durch die ein elektrisches Bauelement 7 angesaugt und gehalten werden kann.

Der Bestückkopf 1 ist in der waagerechten Ebene so positionierbar, dass ein angesaugtes Bauelement 7 in eine Aufsetzlage über einem plattenförmigen waagerecht liegenden Substrat 8 gelangt. Der zugehörige Halter 4 wird dann durch den Hubantrieb 5 soweit abgesenkt, dass das Bauelement 7 auf das Substrat 8 aufsetzt.

Danach wird der Halter 4 angehoben und das Vakuum abgeschaltet. Um sicher zu gehen, dass das aufgesetzte Bauelement 7 nicht am Halter 4 kleben bleibt, wird dieses im Moment des Anhebens durch einen kurzen in die Saugöffnung 6 eingeleiteten Druckluftstoß abgelöst.

Die Halter 4 weisen je eine von der Saugöffnung 6 zur Oberseite durchgehende Längsbohrung 9 auf. Die Oberseiten der Bohrungen 3 sind mit einer Vakuumquelle V über Vakuumleitungen 11 verbunden, die über erste Schaltventile 12 und Vakuumsensoren 13 geführt sind, die die An- oder Abwesenheit eines Bauelementes 7 am Halter 4 überwachen. Die ersten Schaltventile 12 werden so geschaltet, dass sie jeweils alle Vakuumleitungen 11 sperren, an die kein Bauelement 7 angesaugt wird oder ist.

In der Nähe der Unterseite des Gehäuses 2 sind in die Gleitflächen zwischen den Haltern 4 und dem Gehäuse 2 wechselseitige Öffnungen 14 eingeformt, durch die die Halter 4 und die Bohrungswände die Funktion von Schieberventilen erhalten, die als zweite Schaltventile 16 dienen, wobei die Öffnungen 14 in den Haltern 4 mit den mittleren Längsbohrungen 9 verbunden sind. Die einzelnen Öffnungen 14 in den Bohrungswänden sind über verzweigte Verbindungsleitungen 17 mit dem Ausgang eines gemeinsamen zentralen dritten Schaltventils 18 verbunden, das mit einem ersten Eingang mit einem Volumen 19 und mit einem zweiten Eingang mit der Vakuumquelle V verbunden ist. Das Volumen 19 ist über ein Sperrventil 21 mit einer Druckluftquelle P verbunden und wird vor jedem Aufsetzen eines der Bauelemente 7 auf das Substrat 8 mit Druckluft gefüllt, worauf das Sperrventil 21 wieder geschlossen wird.

Die Öffnungen 14 sind so bemessen und angeordnet, dass sie sich bei einem in die Aufsetzposition abgesenkten Halter 4 überdecken, so dass das Schieberventil geöffnet ist. Bei den in der oberen Wartestellung gebliebenen Haltern 4 sind die Öffnungen 14 zueinander deutlich versetzt und die Schieberventile geschlossen. Beim Abheben des Halters 4 vom auf das Substrat 8 aufgesetzten Bauelement 7 wird das dritte Schaltventil 18 auf den ersten Eingang geschaltet. Dadurch wird die im Volumen 19 gespeicherte Druckluft durch die sich überschneidenden Öffnungen 14 beim abgesenkten Halter 4 in dessen Saugöffnung 6 geleitet und das Bauelement 7 sicher abgelöst. Das Vakuum wurde zuvor durch Schließen des ersten Schaltventils 12 unterbrochen, sodass die Druckluft nicht in die Vakuumleitung 11 gelangen kann.

Figur 4 zeigt den Bestückkopf 1 während eines Abholzyklus, in dem die z.B. in Gurten 22 bereitgestellten Bauelemente 7 vom jeweils abgesenkten Halter 4 angesaugt und entnommen werden. Dabei wird das dritte Schaltventil 18 auf die Vakuumquelle V geschaltet und diese über die sich überschneidenden Öffnungen 14 mit der Längsbohrung 9 verbunden. Dadurch wird das über das erste Schaltventil 12 zugeführte Vakuum verstärkt und das abzuholende Bauelement 7 sich angesaugt.

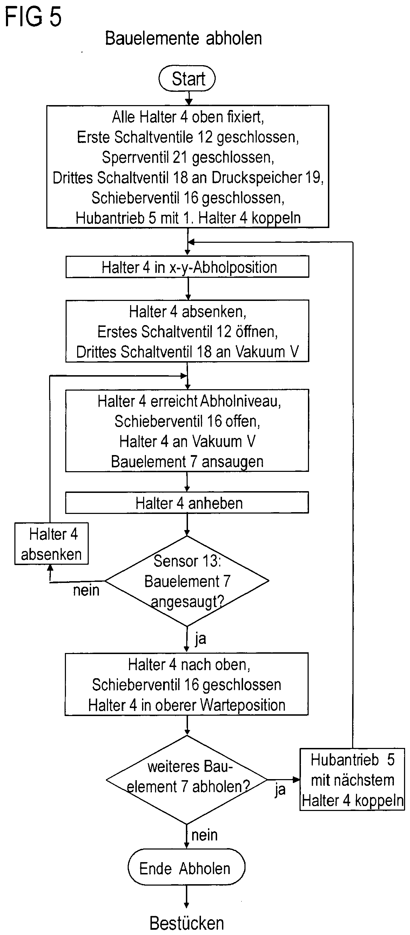

Das Flussdiagramm nach Figur 5 stellt sich selbst erklärend einen Abholzyklus der Bauelemente 7 dar, die sukzessive an die einzelnen Halter 4 des Bestückkopfes 1 angesaugt werden.

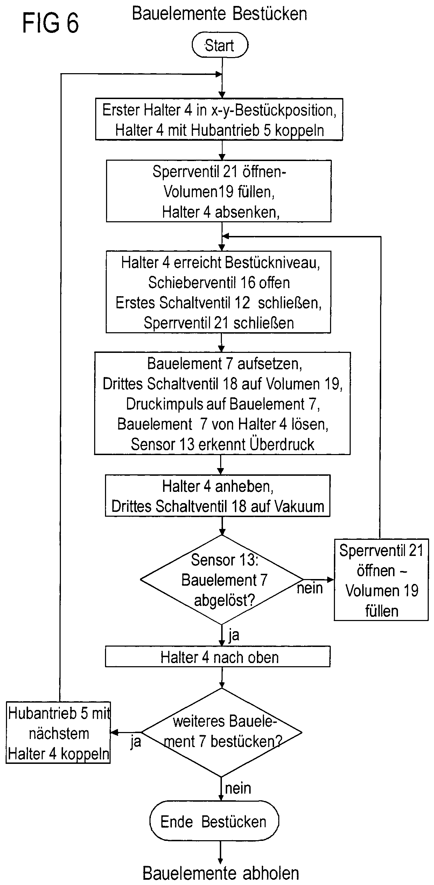

Das Flussdiagramm nach Figur 6 zeigt sich selbst erklärend einen Bestückzyklus, in dem die an die Halter 4 angesaugten Bauelemente 7 sukzessive auf das Substrat 8 aufgesetzt werden.

### Bezugszeichen

- z: senkrechte Richtung
- V: Vakuumquelle
- P: Druckluftquelle
- 1: Bestückkopf
- 2: Gehäuse
- 3: Bohrung
- 4: Halter
- 5: Hubantrieb
- 6: Saugöffnung
- 7: Bauelement
- 8: Substrat
- 9: Längsbohrung

- 11: Vakuumleitung
- 12: erstes Schaltventil
- 13: Vakuumsensor
- 14: Öffnung

- 16: zweites Schaltventil (Schieberventil)
- 17: Verbindungsleitung
- 18: drittes Schaltventil
- 19: Volumen

- 21: Sperrventil
- 22: Gurt

## Patentansprüche

1. Bestückkopf (1) zum Bestücken von Substraten (8) mit elektrischen Bauelementen (7) mit einem Gehäuse (2), an dem mehrere Halter (4) für die Bauelemente (7) in einer zum Substrat (8) senkrechten Richtung (z) verschiebbar gelagert sind, wobei
- die Halter (4) an ihrem dem Substrat (8) zugewandten unteren Ende Saugöffnungen (6) zum Ansaugen der Bauelemente (7) aufweisen,
- die Saugöffnungen (6) schaltbar an eine Vakuumquelle (V) und eine Druckluftquelle (P) anschließbar sind,
- jedem der Halter (4) ein erstes und ein zweites Schaltventil (16) zugeordnet ist, deren Ausgänge mit der zugeordneten Saugöffnung (6) verbunden sind und wobei
- ein Eingang des ersten Schaltventils (12) mit der Vakuumquelle (V) und ein Eingang des zweiten Schaltventils (16) mit der Druckluftquelle (P) verbunden ist, wobei
- das zweite Schaltventil (16) durch die Verschiebebewegung des Halters (4) betätigbar ist, **dadurch gekennzeichnet, dass**
- die Eingänge der zweiten Schaltventile (16) mit einem gemeinsamen dritten Schaltventil (18) verbunden sind, das einen ersten und einen zweiten Eingang umfasst, die schaltbar mit der Druckluftquelle (P) oder der Vakuumquelle verbunden sind, und
- die mit der Saugöffnung (6) verbundenen Ausgänge des ersten und des zweiten Schaltventils (12, 16) einzeln und gemeinsam auf die Vakuumquelle (V) schaltbar sind.

2. Bestückkopf nach Anspruch 1, **dadurch gekennzeichnet, dass** das zweite Schaltventil (16) als mit dem Halter (4) in der Hubrichtung fest gekoppeltes Schieberventil ausgebildet ist.

3. Bestückkopf nach Anspruch 2, **dadurch gekennzeichnet, dass** der Halter (4) und das Gehäuse (2) wechselseitige Gleitflächen aufweisen, die eine lineare Gleitführung für die Halter (4) bilden und an denen das Schieberventil ausgebildet ist.

4. Bestückkopf nach Anspruch 3, **dadurch gekennzeichnet, dass**
- die Gleitflächen mit wechselseitigen Öffnungen (14) versehen sind, die einer oberen Hubstellung zueinander versetzt sind und die sich in einer abgesenkten unteren Hubstellung einander überdecken, und dass
- die Öffnung (14) im Gehäuse mit dem dritten Schaltventil (18) und die Öffnung (14) im Halter (4) mit der Saugöffnung (6) verbunden ist.

5. Bestückkopf nach Anspruch 4, **dadurch gekennzeichnet, dass** die Öffnungen (14) im Halter (4) in der Nähe der Saugöffnungen (6) angeordnet sind.

6. Bestückkopf nach einem der vorhergehenden Ansprüche, **dadurch gekennzeichnet, dass** der erste Eingang des dritten Schaltventils (18) über ein Volumen (19) und ein Sperrventil (21) mit der Druckluftquelle (P) verbunden ist.

## Claims

1. Placement head (1) for populating substrates (8) with electrical components (7) with a housing (2), on which a plurality of mountings (4) for the components (7) are displaceably located in a direction perpendicular (z) to the substrate (8), wherein
- the mountings (4) have suction orifices (6) at their lower end facing the substrate (8) to apply suction to the components (7),
- the suction orifices (6) can be switchably connected to a vacuum source (V) and a compressed air source (P),
- each of the holders (4) is connected to a first and a second switching valve (16) whose outlets are connected with the associated suction orifice (6) and wherein
- an inlet of the first switching valve (12) is connected to the vacuum source (V) and an inlet of the second switching valve (16) is connected to the compressed air source (P), and wherein
- the second switching valve (16) can be actuated by the displacement movement of the mounting (4), **characterised in that**
- the inlets of the second switching valves (16) are connected to a common third switching valve (18), which comprises a first and a second inlet, which can be switched to connect with the compressed air source (P) or the vacuum source, and
- the outlets connected to the suction orifice (6) of the first and second switching valve (12, 16) can be individually and jointly switched to the vacuum source (V).

2. Placement head in accordance with claim 1, **characterised in that** the second switching valve (16) is configured as a slide valve with a fixed attachment to the mounting (4) in the stroke direction.

3. Placement head in accordance with claim 2, **characterised in that** the mounting (4) and the housing (2) have reciprocal sliding surfaces, which form a linear sliding guide for the holder (4) and on which the slide valve is configured.

4. Placement head in accordance with claim 3, **characterised in that**
- the sliding surfaces are provided with reciprocal orifices (14), which are displaced with respect to one another and which overlap one another in a lowered stroke position, and that
- the orifice (14) in the housing is connected to the third switching valve (18) and the orifice (14) in the mounting (4) is connected to the suction orifice (6).

5. Placement head in accordance with claim 4, **characterised in that** the orifices (14) in the holder (4) our arranged adjacent to the suction orifices (6).

6. Placement head in accordance with one of the preceding claims, **characterised in that** the first inlet of the third switching valve (18) is connected by means of a volume (19) and a lock valve (21) to the compressed air source (P).

## Revendications

1. Tête d'implantation (1) pour implanter sur des substrats (8) des composants électriques (7), avec un boîtier (2) sur lequel plusieurs fixations (4) pour les composants (7) sont montées mobiles dans un sens (z) perpendiculaire au substrat (8),
- les fixations (4) présentant à leur extrémité inférieure tournée vers le substrat (8) des ouvertures d'aspiration (6) pour aspirer les composants (7),
- les ouvertures d'aspiration (6) étant aptes à être raccordées, en pouvant être commandées, à une source de vide (V) et à une source d'air comprimé (P),
- à chacune des fixations (4) sont associées des première et deuxième soupapes de commande (16) dont la sortie est reliée à l'ouverture d'aspiration (6) associée, et
- une entrée de la première soupape de commande (12) étant reliée à la source de vide (V) tandis qu'une entrée de la deuxième soupape de commande (16) est reliée à la source d'air comprimé (P),
- la deuxième soupape de commande (16) est apte à être actionnée grâce au mouvement coulissant de la fixation (4), **caractérisée en ce que**
- les entrées des deuxièmes soupapes de commande (16) sont reliées à une troisième soupape de commande commune (18) qui comprend des première et deuxième entrées reliées, en étant aptes à être commandées, à la source d'air comprimé (P) ou à la source de vide, et
- les sorties, reliées à l'ouverture d'aspiration (6), des première et deuxième soupapes (12, 16) sont aptes à être commandées individuellement et conjointement pour être reliées à la source de vide (V).

2. Tête d'implantation selon la revendication 1, **caractérisée en ce que** la deuxième soupape de commande (16) est conçue comme une soupape à tiroir qui est couplée de manière fixe à la fixation (4) dans le sens de la course.

3. Tête d'implantation selon la revendication 2, **caractérisée en ce que** la fixation (4) et le boîtier (2) présentent des surfaces de glissement alternées qui forment une glissière linéaire pour les fixations (4) et sur lesquelles est formée la soupape à tiroir.

4. Tête d'implantation selon la revendication 3, **caractérisée en ce que**
- les surfaces de glissement sont pourvues d'ouvertures (14) alternées qui sont décalées les unes par rapport aux autres dans une position de course supérieure, et qui se recouvrent dans une position de course inférieure abaissée, et **en ce que**
- l'ouverture (14) prévue dans le boîtier est reliée à la troisième soupape de commande (18) tandis que l'ouverture (14) prévue dans la fixation (4) est reliée à l'ouverture d'aspiration (6).

5. Tête d'implantation selon la revendication 4, **caractérisée en ce que** les ouvertures (14) prévues dans la fixation (4) sont disposées près des ouvertures d'aspiration (6).

6. Tête d'implantation selon l'une des revendications précédentes, **caractérisée en ce que** la première entrée de la troisième soupape de commande (18) est reliée par l'intermédiaire d'un volume (19) et d'un clapet antiretour (21) à la source d'air comprimé (P).
